# EUROPEAN PATENT APPLICATION

(11) **EP 1 178 539 A2**
(43) Date of publication of application: **06.02.2002**
(21) Application number: 01113993.8
(22) Date of filing: 08.06.2001
(51) Int. Cl.: H01L 29/78, H01L 29/872

(54) **Schottky field-effect transistor**

(30) Priority: 29.06.2000 US 608456
(71) Applicant: SILICONIX Incorporated, Santa Clara California 95054 (US)
(72) Inventor: Chang, Mike F., Cupertino, CA 95104 (US); Korec, Jacek, Dr., San Jose, CA 95120 (US)
(74) Representative: Kolb, Georg

(57) **Abstract**

A Schottky field-effect transistor (SFET) is described. The SFET is a three-terminal trench-gated device with a Schottky interface between a metal layer and the top surface of the semiconductor substrate. The gate electrodes are doped with material of the same conductivity type as the substrate, and the mesas between the trenches are relatively narrow. As a result, the electric fields produced by the gate electrodes generate depletion regions which merge at the center of the mesa to pinch off current flow. The SFET is turned on by applying a voltage opposite to the doping of the gate and substrate, creating accumulation regions along the walls o the trenches. In this condition the SFET exhibits a very low forward voltage drop across the Schottky interface. A SFET can be turned on or off with a relatively small swing in the gate voltage (e.g., ±1 V), and it is therefore an ideal power switch for use with supply voltages of less than 3 V.

## Description

### Field of the Invention

This invention relates to semiconductor switches.

### Background of the Invention

Semiconductor switches, typically MOSFETs, are widely used to control the flow of power to electronic devices such as computers and cellular telephones. The supply voltage at which these devices operate is decreasing rapidly―from 5 V to 3.3 V and below. It is likely that supply voltages will drop to 1 V or less within the foreseeable future.

To accommodate this decrease in supply voltage, the challenge is to develop power switches that can be switched on and off with a control signal of 1 V or less and that have a very low forward voltage drop when they are conducting. It is impossible to lower the threshold voltage of a conventional enhancement-mode power MOSFET below 0.5 V without creating an excessive leakage current when the device is turned off; and a conventional MOSFET with a threshold voltage of 0.5 V or more cannot be fully turned on unless the gate voltage is greater than 1.5 V. Depletion mode MOSFETs have a restricted current capability and the use of bipolar transistors as switches is limited by the need to provide a continuous base current.

Furthermore, in many applications a Schottky diode is connected in series with the power switch to protect the circuitry against a reverse bias condition. When this is done, the forward voltage drop across the Schottky diode creates a further power loss and reduces the efficiency of the system. To prevent this from being a significant power dissipation factor, the voltage drop across the Schottky diode should be much less than the supply voltage.

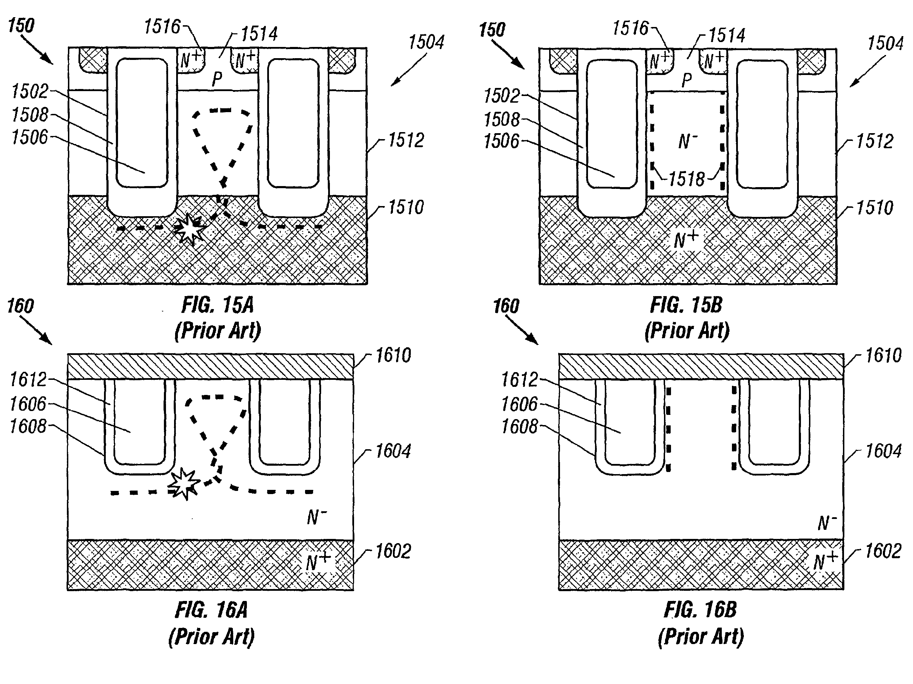

Application No 09/476,320 describes a Barrier Accumulation-Mode Field-Effect Transistor (Barrier-ACCUFET), a cross-sectional view of which is shown in **Figs. 15A** and **15B.** The Barrier-ACCUFET 150 includes trenches 1502 formed in a semiconductor substrate 1504. A gate 1506 is located in the trenches 1502, insulated by a dielectric layer 1508 from the substrate 1504. Substrate 1504 also includes a heavily-doped N+ region 1510 and an N- drift region 1512, which together form the drain of the device. A P-body 1514 and N+ source regions 1516 are formed near the surface of the substrate 1504. The gate 1506 is doped with N-type material, creating charge depletion regions in the N- drift region 1512. The parameters of the device are set to ensure that these depletion regions merge at the center of the mesa between the trenches when the gate is biased off, as shown in **Fig. 15A**, pinching off the current flow between the N+ source regions 1516 and the N+ region 1510. The electric field emanating from the gate is used to shield the P body against the punchthrough phenomenon. To ensure that the depletion regions merge, the charge density of the dopant in the portion of the N- drift region 1512 that is located in the mesa, calculated as an integral of the net doping concentration across the width of the mesa, is less than 5 x 10¹² cm⁻².

The two-dimensional pinching effect caused by the gate electrodes and the junction between P body 1514 and N- drift region 1512 allows the net charge density in the P body region to be much lower than in conventional trench MOSFETs. This in turn sllows a design of a MOSFET with a short channel and a low threshold voltage while maintaining a reasonable thickness of the dielectric layer 1508, which is typically an oxide.

As shown in **Fig. 15B,** when the gate voltage of the Barrier-ACCUFET is increased, the depletion regions surrounding the trench contract, and accumulation regions 1518 are formed in the N- drift region 1512 adjacent to the trench. Accumulation regions 1518 provide a low-resistance current path between the N+ source regions 1516 and the drain, and reduce the voltage drop across the device in a conduction mode.

In one embodiment of a Barrier-ACCUFET, a deep trench reaching the N+ substrate _ is used to minimize the on-resistance of the switch, and the portion of the dielectric layer 1508 at the bottom of the trench is made thicker to reduce the strength of the electric field at the bottom comer of the trench. The strength of the electric field normally reaches a maximum at this comer, and the dielectric layer there is particularly vulnerable to damage from impact ionization and hot carrier generation.

Another device that can be used to control a current is known as a Trench-MOS-Barrier Schottky diode (TMBS-diode). A TMBS-diode is described, for example, in U.S. Patent No. 5,365,102 to Mehtrota et al. and U.S. Application No. 08/832,012, now U.S. Patent No. 5,XXX,XXX, to Williams et al.

A major disadvantage of a Schottky diode is its relatively high reverse leakage current, which is typically orders of magnitude higher than the reverse leakage of a PN junction diode. Moreover, the leakage current in a Schottky diode is strongly dependent on the magnitude of the reverse voltage, as a consequence of reverse-voltage-induced barrier-lowering at the rectifying metal-semiconductor interface (sometimes referred to as a "Schottky-barrier"). Unfortunately, using a metal which has a large Schottky barrier height and thereby reducing the leakage current increase the forward voltage drop across the diode. This leads to a difficult trade-off between the forward and reverse bias characteristics of the diode. Commercially available Schottky-diodes use metallization schemes with barrier heights larger than 0.6 eV. As a result, there are no known Schottky diodes on the market with a forward voltage drop below 0.40 V at 100 A/cm² and room temperature.

A TMBS-diode reduces the trade-off between forward voltage drop and reverse leakage current by taking advantage of a pinching effect similar to that described above in connection with the Barrier-ACCUFET. **Figs. 16A** and **16B** show cross-sectional views of a TMBS-diode 160 in the off- and on-states, respectively. TMBS-diode 160 is formed in an N+ substrate 1602 and an N- layer 1604. The gate electrodes 1606 are located in trenches 1608 which form a mesa between them. The Schottky interface is between the top surface of N- layer 1604 and a Schottky metal 1610. Schottky metal 1610 is connected to the gate electrodes 1606. As shown in **Fig. 16A,** the high electric field appearing at the bottom comer of the trench can lead to severe reliability problems by charging the gate dielectric layer 1612 with hot carriers. As proposed in Application No. 08/832,012, this problem can be alleviated somewhat by introducing a deep PN junction with a breakdown voltage lower than that of the trench structure.

### Summary of the Invention

A Schottky field-effect transistor (SFET) switch in accordance with this invention is formed in a semiconductor substrate having first and second trench segments separated by a mesa. A metal layer forming a Schottky interface is formed on the surface of the mesa. The metal layer and the substrate, represent the anode and cathode terminals, respectively, of the switch. A conductive material in the trench segments forms a gate electrode, the gate electrode being insulated by a dielectric layer from the semiconductor substrate and the metal layer. In one group of embodiments, the substrate is generally doped with N-type dopant, and the conductive material which forms the gate electrode is also doped with N-type dopant. This creates depletion regions in the mesa which can merge to pinch off current between the anode and the cathode.

The SFET switch is controlled by the voltage on the gate. When the gate is biased positive, accumulation regions form along the walls of the trench and a current can flow from the anode layer to the cathode. When the gate is biased negative, the depletion regions expand, choking off practically any current between the anode and cathode terminals. For example, if the anode is biased at 1 V and the cathode is grounded, a voltage of 1 V applied to the gate produces a forward voltage drop of less than 0.3 V at 100 A/cm² and room temperature. On the other hand, a voltage of-1 V applied to the gate reduces the forward anode current to less than 1 mA/mm². When the Schottky interface is reverse-biased, the switch blocks current independent of the gate bias. Applying a positive or negative voltage to the gate increases or decreases the current, respectively, by a factor of two or three. If the absolute value of the negative blocking gate voltage is larger than the reverse bias applied to the switch, the leakage current can be suppressed by more than two orders of magnitude.

The SFET switch of this invention is thus ideally suited to use with low supply voltages of, for example, 1 V or less.

The switch can also be formed in a P-type substrate, in which case the polarities of the gate dopant and voltages are reversed.

The SFET switch may be formed in a substrate which includes a lightly doped epitaxial layer grown on a heavily doped semiconductor piece. In many embodiments, the trench extends through the epitaxial layer into the heavily doped material. To protect the dielectric layer in the trench, typically an oxide, the dielectric layer may be made thicker at the bottom of the trench. In addition, a PN clamping diode may be formed integrally in parallel with the trench structure to prevent damage to the dielectric layer from high electric fields. The clamped diode is designed to have a breakdown voltage that is less than a voltage that would damage the dielectric layer.

### Brief Description of the Drawings

**Figs. 1A** and **1B** are cross-sectional views of a Schottky field-effect transistor (SFET) of this invention.
**Fig. 2** is a circuit diagram of a Schottky diode connected in series with a depletion mode MOSFET.
**Figs. 3A** and **3B** show proposed symbolic representations of an N-type SFET and a P-type SFET, respectively.
**Fig. 4** is a graph of the doping profile through the mesa of an N-type SFET.
**Fig. 5** is a graph of the doping profile through the protective clamping diode of an N-type SFET.
**Figs. 6A** and **6B** illustrate steps of a process sequence for manufacturing an N-type SFET.
**Figs. 7** and **8** are graphs showing the forward conduction characteristics of an N-type SFET.
**Fig. 9** is a graph showing the reverse characteristics of an N-type SFET.
**Fig. 10** is a graph of the doping profile through the mesa of a P-type SFET.
**Fig. 11** is a graph of the doping profile through the protective clamping diode of a P-type SFET.
**Figs. 12** and **13** are graphs showing the forward conduction characteristics of a P-type SFET.
**Fig. 14** is a graph showing the reverse characteristics of a P-type SFET.
**Figs. 15A** and **15B** are cross-sectional views of a Barrier-Accumulation Mode Field-Effect Transistor (Barrier ACCUFET).
**Figs. 16A** and **16B** are cross-sectional views of a Trench-MOS-Barrier-Schottky Diode (TMBS-diode).

The drawings are generally not to scale.

### Description of the Invention

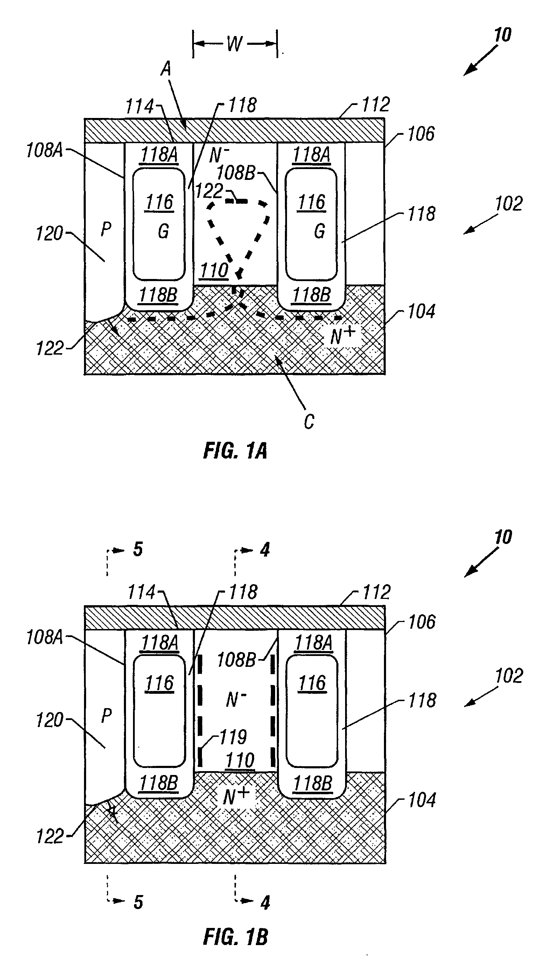

**Figs. 1A** and **1B** show cross-sectional views of a Schottky field-effect transistor (SFET) switch 10 in accordance with this invention. **Fig. 1A** shows switch 10 in a current-blocking state; **Fig. 1B** shows switch 10 in a conductive state. In this embodiment, the switch is formed in a silicon substrate 102 which includes a heavily doped N+ piece 104 on which a lightly doped N- epitaxial (epi) layer or drift region 106 is grown. N+ piece 104 is generally doped with arsenic to a doping concentration of about 2 x 10¹⁹ cm⁻³. A trench 108 which includes segments 108A and 108B is formed in substrate 102, the trench segments being separated by a mesa 110. A metal layer 112 is deposited on the substrate 102 and forms a rectifying Schottky interface 114 with the top surface of mesa 110. Each of trench segments 108A and 108B (sometimes referred to collectively as trenches 108) contains a conductive gate material, in this case polysilicon, which is doped with N-type dopant, typically phosphorus. The polysilicon gate is insulated from the substrate 102 and the metal layer 112 by a dielectric layer 118, which in this embodiment is silicon dioxide. As shown, dielectric layer 118 includes thin portions adjacent the side walls of the trenches 108 and thicker portions 118A and 118B at the top and bottom of the trenches, respectively.

Metal layer 112 represents the anode and N+ region 104 represents the cathode of SFET switch 10. A metal cathode contact (not shown) would typically be formed on the back side of N+ region 104, although in some embodiments the cathode is contacted by an N+ sinker extending from the front side of the substrate. Since switch 10 is an N-type device, the metal in layer could be titanium, the barrier at the metal-semiconductor Schottky interface 114 is 0.51 eV. Gate 116 is typically contacted somewhere in the third dimension, outside the plane of the paper.

It will be understood that, viewed from above, the mesa between trenches 108 can take many shapes, e.g., rectangular, square, hexagonal, or longitudinal stripes, and the trenches are connected together in a lattice which defines numerous mesas or "cells", all of which are connected in parallel.

When the anode is biased positive with respect to the cathode, the Schottky interface 114 is forward-biased, and current flow through the N- drift region 106 is controlled by the lateral electric field generated by the gate electrode 116. There are three modes of operation. First, the gate electrode 116 can be connected directly to the metal layer 112 (i.e., the gate is shorted to the anode). In this mode the device operates like the TMBS-diode described in the above-referenced U.S. Patent No. 5,XXX,XXX to Williams et al. Second, if a positive voltage is applied to the gate electrode 116, an accumulation layer 120 is formed in the mesa adjacent the side wall of the trench, as shown in **Fig. 1B.** The accumulation layer provides a very low-resistance path, so only the barrier represented by the Schottky interface 114 needs to be overcome. This yields a very low voltage drop for the device. Third, if the gate is biased negative, the field produced by the doping of the gate is reinforced, the depletion regions denoted by the dashed lines 122 shown in **Fig. 1A** merge, and current flow through the switch is impeded. The normally leaky Schottky interface is supported by the pinching effect of the electric field generated by the gate electrodes.

If the anode is biased negative with respect to the cathode, the Schottky interface 114 is reverse-biased, and a substantial current will not flow regardless of how the gate is biased. Applying a bias to the gate, however, can increase or reduce the leakage current by a factor of 2 or 3. If the gate is biased positively, the leakage current increases; if the gate is biased negatively, the leakage current decreases. If the gate is biased negative at a level greater than the reverse bias on the anode-cathode terminals of switch 10, however, the leakage current is suppressed by more than two orders of magnitude.

At V_{A} = V_{G}, the Schottky diode, with its ultra-low forward voltage drop, defines the forward and reverse characteristics of the device which are similar to those of a TMBS-diode. The reverse characteristic is a flat, voltage-independent leakage current; this is due to the pinching effect of the field generated by the gate. Forward biasing the gate electrode with respect to the cathode in the conduction mode (V_{A} > V_{G} > V_{C}) further reduces the resistance of the device in the conduction mode. Applying a reverse bias to the gate in the conduction mode (V_{A} > V_{C} >V_{G}) results in a blocking of the current.

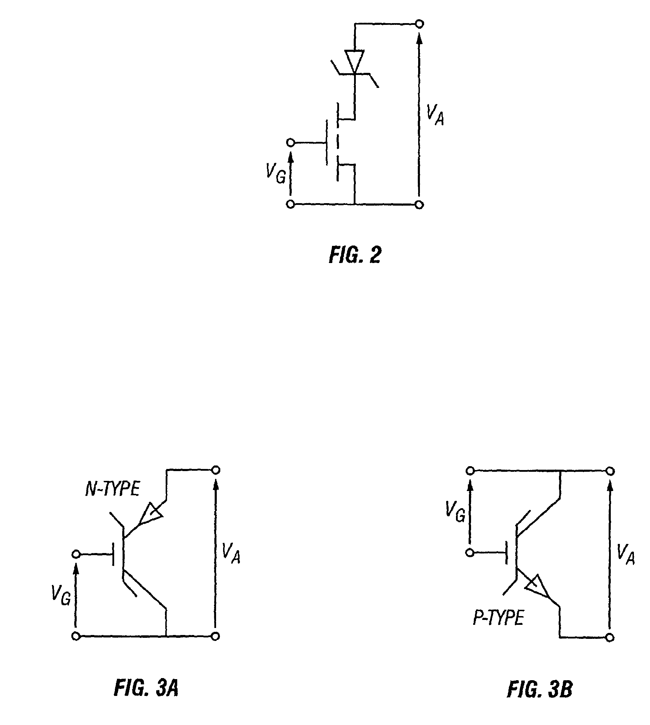

The behavior of the device is somewhat similar to that of a serial connection of a Schottky diode and a depletion mode MOSFET, shown in **Fig. 2. Figs. 3A** and **3B** show proposed symbols for the SFET fabricated using N-type and P-type substrates, respectively.

In one embodiment, as shown in **Figs. 1A** and **1B,** a P-type region 120 is formed in substrate 102 by implantation outside mesa 110. Region forms a PN junction 122 with the remaining N-type portion of substrate 102, which represents a clamping diode that at a desired voltage to protect the trench structure and in particular prevent the field strength from reaching the point at which hot carrier injection into the gate dielectric layer 118 occurs. The technique of doping P region 120 to provide a desired breakdown voltage at junction 122 is well known (see, e.g., Sze, *Physics of Semiconductor Devices,* 2^{nd} Ed., John Wiley & Sons (1981), pp. 96-109, incorporated herein by reference).

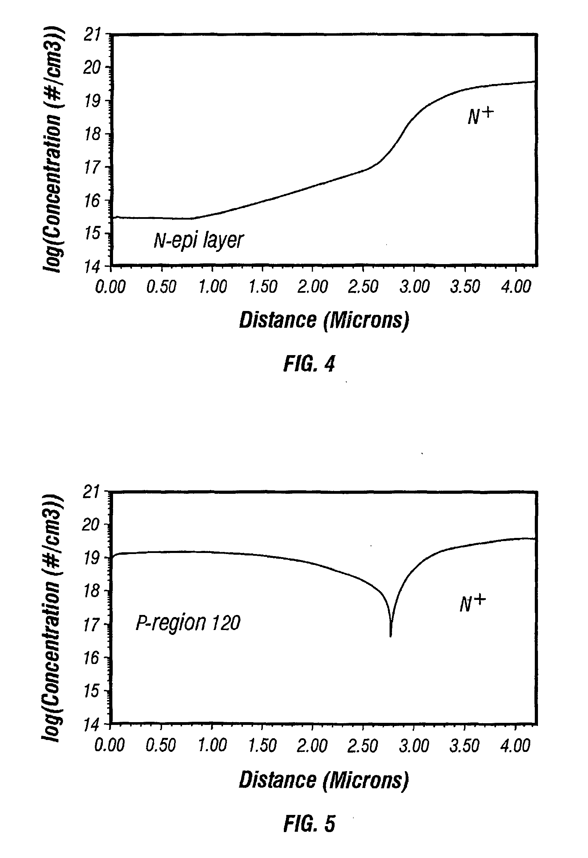

The distance between trenches 108 (which is also the width W of mesa 110, see **Fig. 1A**) is preferably less than 1.2 µm and more preferably between 0.4 and 0.6 µm. The doping concentration in the drift region 106 is preferably less than 1 x 10¹⁶ cm⁻³. Normally, the doping concentration in N-epi layer 106 will actually be graduated, with the concentration increasing gradually with distance from the surface of layer 106 to a relatively sharp increase at the junction between N-epi layer 106 and the N+ piece 104. **Fig. 4** is graph of the doping concentration in a vertical cross-section 4-4 through mesa 110 in one embodiment, and **Fig. 5** is a graph of the doping concentration in a vertical cross-section 5-5 through P-region 120 in the same embodiment.

A SFET switch can be manufactured by any one of several known process flows for making trench MOSFETs. There are several differences, however, including: (a) no source or body regions are formed; (b) the metallization scheme used on the top surface of the substrate should result in a Schottky interface with a low barrier height, preferably below 0.6 eV and more preferably around 0.5 eV.

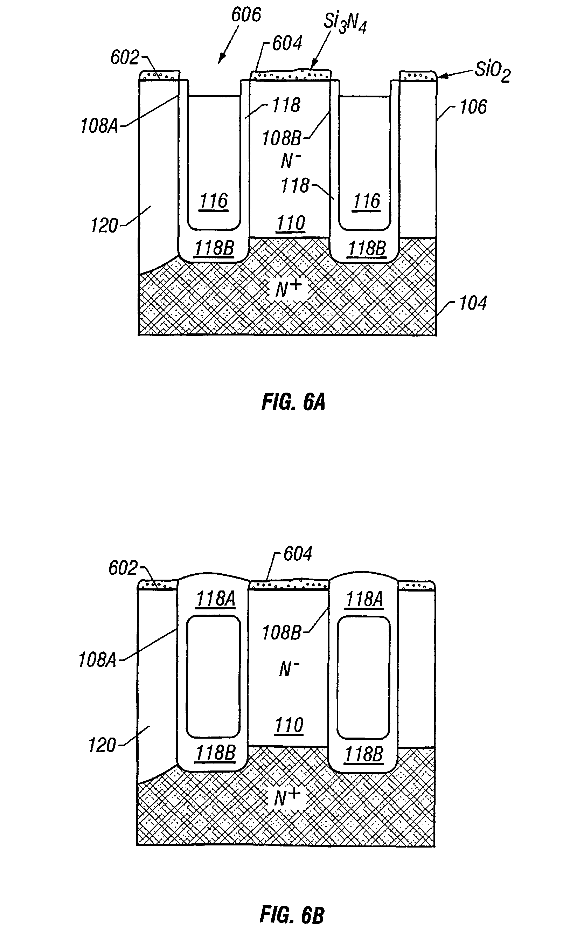

**Figs. 6A** and **6B** illustrate the steps of one process for manufacturing SFET 10 shown in **Fig. 1.** N- epi layer 106 is grown on an N+ silicon piece 104 using a known type of epitaxial reactor. Epi layer 106 may include two or more sublayers; in this embodiment, an upper sublayer is 3.7 µm thick and has an average doping concentration of 2 x 10¹⁵ cm⁻³ and a lower sublayer is 0.5 µm thick and has an average doping concentration of 3 x 10¹⁷ cm⁻³. A thin pad oxide layer 602 and a silicon nitride layer 604 are formed on the top surface of epi layer 106 and patterned with openings where the trenches 108 are to be located. For example, pad oxide layer 602 can be 30 nm thick and silicon nitride layer 604 can be 150 nm thick. Trenches 108 are formed by cutting through epi layer to the N+ silicon, preferably by dry-etching. A sacrificial oxide layer is grown on the walls of the trenches and etched back to eliminate any defects caused during the formation of the trenches. In one embodiment, trenches 108 are 0.8 µm wide and 2.2 µm deep and are separated laterally by 0.4 µm.

As shown in **Fig. 6A,** gate oxide layer 118 is thermally grown on the side walls and floor of the trenches. For example, the thicker portion 118B can be formed in the lower portion of the trenches 108 by the techniques described in U.S. Patent No. 4,914,058 to Blanchard, issued April 3, 1990, and in Application No. **[Attorney Docket No. M-8200 US]**, by Giles et al., filed June 8, 2000, both of which are incorporated herein by reference. Alternatively the thicker portion of the dielectric layer may include a polysilicon plug as taught in the above-referenced Application No. **[Attorney Docket No. M-8200]** and in Application No. **[Attorney Docket No. 8492],** by Ng et al., filed June 8, 2000, incorporated herein by reference. The thickness of the oxide layer 118 on the walls of the trenches can be 50 nm and the thickness of the thicker portion 118B can be 200 nm, for example. Polysilicon is deposited in the trenches and etched back to a level below the surface of epi layer 106 to form gate electrodes 116. The polysilicon is doped with N-type material to a concentration of 10¹⁹ cm⁻³, for example. The etchback of the polysilicon leaves at recess 606 which can be 0.1 µm deep.

As shown in **Fig. 6B**, using the nitride layer 604 as a mask the exposed polysilicon is thermally oxidized to an oxide thickness of 0.2 µm, for example, to yield thicker portions 118A and a generally flat topology on the top surface of the structure. The silicon nitride layer 604 and pad oxide layer 602 are removed with conventional etchants, yielding a self-aligned definition of the contact areas. At some location, contact windows to the gate are opened through the thicker portions 118A, using a dedicated mask and a dry-etching (reactive ion etch) process. Referring to **Figs. 1A** and **1B,** metal layer 112 is then deposited on the top surface of the mesa 110 and the thicker oxide portion 118A to form the Schottky interface 114. Because of the high doping concentration of the polysilicon gate, metal layer 112 forms an ohmic contact with the polysilicon at the locations of the gate contact windows. Metal layer 114 is patterned using a photoresist mask to form anode and gate electrodes. A metal layer (not shown) is deposited on the back side of the N+ substrate to form an ohmic contact to the cathode.

In the case of an N-type device a preferred metal for layer 112 is titanium, which produces a Schottky barrier of 0.51 eV, but other materials such as titanium silicide, tungsten or tungsten silicide could also be used.

If a clamping diode is desired to protect the gate oxide layer, the structure can be masked before pad oxide layer 602 and nitride layer 604 are formed, and a P-type dopant such as boron is implanted at a dose of 8 x 10¹⁵ cm⁻² and an energy of 80 keV. The implanted dopant can be driven in at 1050 °C for 60 minutes and 950 °C for 130 minutes to form P-region 120, having an average doping concentration of about 10¹⁹ cm⁻³.

The result is SFET 10 shown in **Fig. 1.** The doping profiles of the mesa 110 and P-region 120 are shown in **Figs. 4** and **5,** respectively. Based on simulations (using SUPREM and PISCES), the resulting breakdown voltage of the trench structure was about 18 V, and the clamping diode had a breakdown voltage of about 12 V.

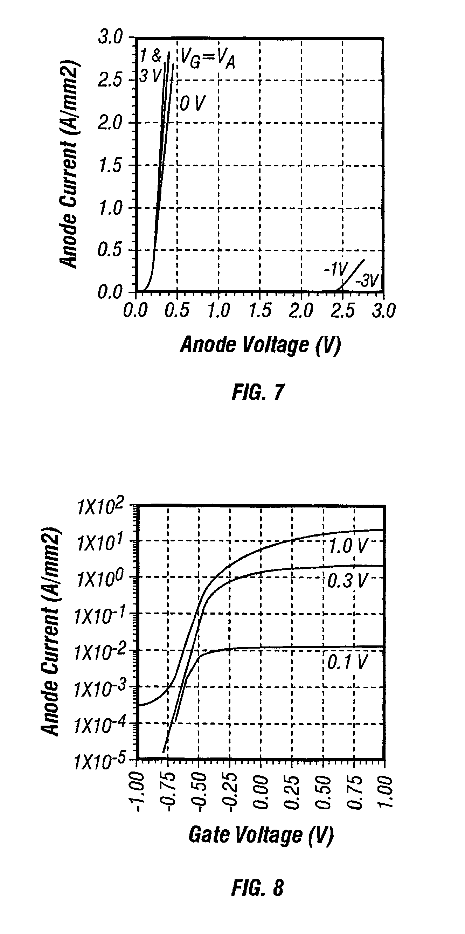

**Fig. 7** shows the forward conduction characteristics of SFET 10 (anode current density as a function of anode voltage (V_{A}) for various gate voltages (V_{G})). Note that with V_{G} at 0 V or higher, SFET 10 turns fully on and the forward voltage drop is well under 0.5 V. The same is true for the case where V_{G} = V_{A}. On the other hand, when V_{G} is -1 V or less, the device does not begin to turn on until V_{A} is almost equal to 2.5 V.

**Fig. 8** is a graph on semilog paper of the anode current density of SFET 10 as V_{G} swings between +1 V and -1 V for several values of V_{A}. When V_{A} is equal to 1 V the current density varies between 20 A/mm² and 0.3 mA/mm² as V_{G} varies between +1 V and -1 V. Clearly, the SFET is an ideal power switch for operation in the voltage range below 3 V. Among the advantages of the SFET are the following:
1. Its built-in Schottky diode has a voltage drop of less than 0.3 V at a current density of 100 A/cm² and room temperature.
2. The device can be switched on and off with a gate voltage swing in the range of ±1 V.

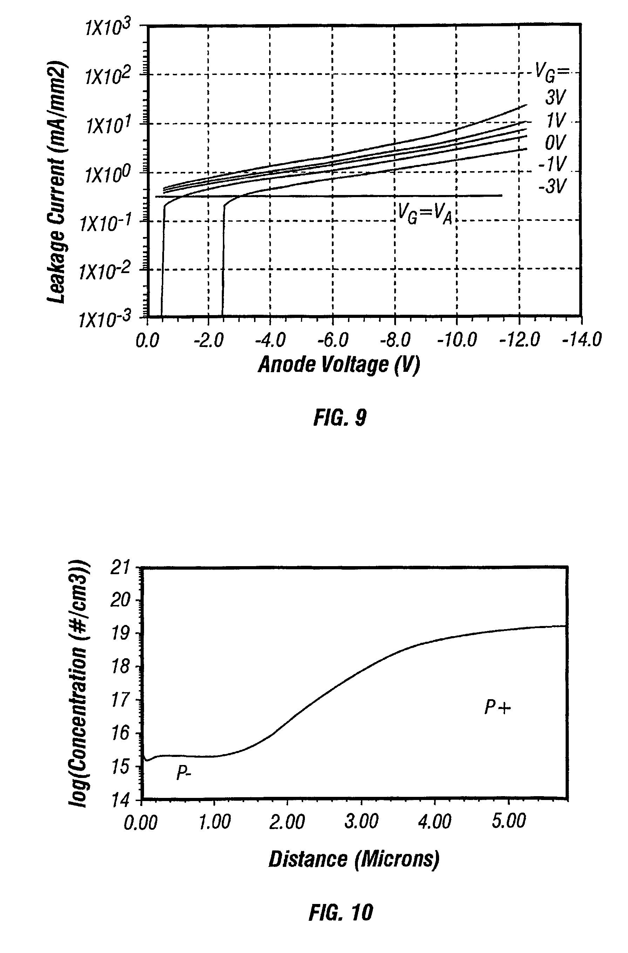

**Fig. 9** is a graph on semilog paper of the simulated reverse characteristics of SFET 10, showing the leakage current density as a function of V_{A} for various values of V_{G}. This graph clearly indicates that the leakage current can be reduced to essentially zero by applying a V_{G} that is greater than V_{A}, in absolute terms, i.e., |V_{G}| > |V_{A}|.

While the embodiment described above is an N-type device, the principles of this invention are also applicable to P-type devices. Table 1 shows the design parameters of an illustrative P-type SFET.

**Table 1**

| | |
|---|---|
| Mesa width | 0.4 µm |
| Trench width | 0.8 µm |
| Trench depth | 2.2 µm |
| Bottom oxide thickness | 200 nm |
| Gate oxide thickness | 50 nm |
| Gate | P+ polysilicon |
| Polysilicon recess | 0.2 µm |
| Epi layer structure | Upper sublayer: 4.3 µm, 2 x 10¹⁵ cm⁻³, boron Lower sublayer: 1.5 µm, 3 x 10¹⁷ cm⁻³, boron |
| Surface doping dose | 1 x 10¹¹ cm⁻² @ 40 keV (BF₂ implanted through gate oxide) |
| Clamping diode dose | 8 x 10¹⁵ cm⁻² @ 80 keV, phosphorus |
| Schottky barrier | 0.51 eV |

The shallow BF₂ implant is used to define the doping concentration at the surface of the epi layer to compensate for the effect of boron redistribution at the top surface during thermal oxidation and annealing processes. The BF₂ is implanted through the gate oxide, which at this point covers the top surface of the mesa.

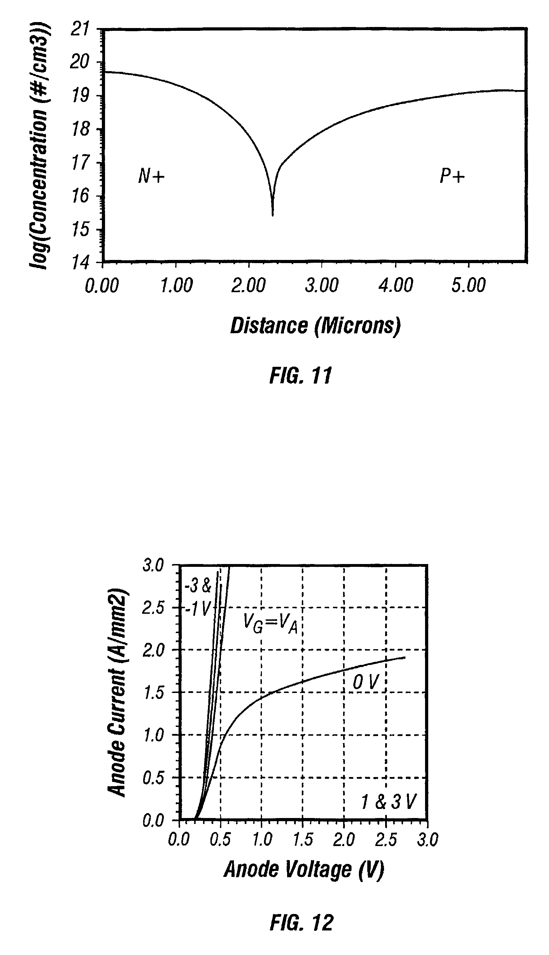

**Fig. 10** shows the doping concentration in a vertical section through the mesa and **Fig. 11** shows the doping concentration through the clamping diode. In **Fig. 10** it is evident that the dopant from the lower epi sublayer has outdiffused, increasing the doping concentration of the lower part of the upper epi sublayer.

**Figs. 12-14** are graphs showing the simulated characteristic of the P-type SFET characterized in Table 1. **Fig. 12** shows the forward conduction characteristics of the P-type SFET (anode current density as a function of anode voltage (V_{A}) for various gate voltages (V_{G})). With V_{G} at -1 V or less, the SFET turns on (V_{A} is under 0.5 V). The same is true for the case where V_{G} = V_{A}. On the other hand, when V_{G} is 1 V or more, the device does not begin to turn on until V_{A} is in excess of 2.5 V. As expected, the forward voltage drop across a P-type SFET is slightly greater than the forward voltage drop across an N-type SFET. This is due to the lower mobility of holes as compared to electrons.

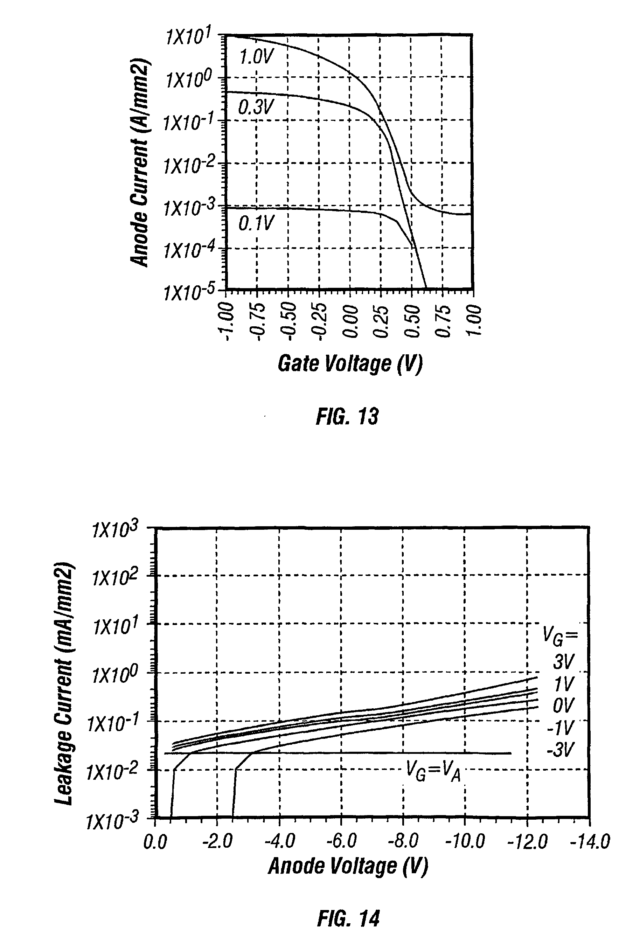

**Fig. 13** is a graph on semilog paper of the anode current density of the P-type SFET 10 V_{G} swings between +1 V and -1 V for several values of V_{A}. When V_{A} is equal to 1 V the current density varies between 10 A/mm² and less than 1mA/mm² as V_{G} varies between -1 V and +1 V.

**Fig. 14** is a graph on semilog paper of the simulated reverse characteristics of SFET 10, showing the leakage current density as a function of V_{A} for various values of V_{G}.

While specific embodiments of this invention have be described above, those skilled in the art will appreciate that numerous alternative embodiments can be designed and built in accordance with the broad principles of this invention.

## Claims

1. A Schottky field-effect transistor switch comprising:
a semiconductor substrate having first and second trench segments separated by a mesa;
a metal layer forming a Schottky interface with a surface of the mesa; and
a conductive material in the trench segments, the conductive material being insulated by a dielectric layer from the semiconductor substrate and the metal layer.

2. The Schottky field-effect transistor switch of Claim 1 wherein the substrate is generally doped with a dopant of a first conductivity type.

3. The Schottky field-effect transistor switch of Claim 2 wherein the conductive material in the trench segments is doped with a dopant of the first conductivity type.

4. The Schottky field-effect transistor switch of Claim 2 wherein the substrate comprises a region of a second conductivity type outside of the mesa, the region of second conductivity type forming a PN junction with a remaining portion of the substrate.

5. The Schottky field-effect transistor switch of Claim 4 wherein a reverse breakdown voltage of the PN junction is less than a breakdown voltage of the dielectric layer.

6. The Schottky field-effect transistor switch of Claim 1 wherein the substrate comprises a lightly doped layer near a surface of the substrate and a heavily doped region beneath the lightly doped layer.

7. The Schottky field-effect transistor switch of Claim 6 wherein a thickness of the dielectric layer is greater at a bottom of the trench than on a side wall of the trench.

8. The Schottky field-effect transistor switch of Claim 7 wherein the trench extends into the heavily doped region.

9. The Schottky field-effect transistor switch of Claim 1 wherein the doping concentration in the mesa is less than 1 x 10¹⁶ cm⁻³.

10. The Schottky field-effect transistor switch of Claim 1 wherein the width of the mesa is less than 1.2 µm.

11. The Schottky field-effect transistor switch of Claim 10 wherein the width of the mesa is between 0.4 µm and 0.6 µm.

12. The Schottky field-effect transistor switch of Claim 1 wherein the barrier height of the Schottky interface is less than 0.6 eV.

13. The Schottky field-effect transistor switch of Claim 12 wherein the barrier height of the Schottky interface is about 0.5 eV.

14. The Schottky field-effect transistor switch of Claim 1 wherein the substrate is generally doped with a dopant having a negative conductivity and the metal layer comprises titanium or titanium silicide.

15. The Schottky field-effect transistor switch of Claim 1 wherein the substrate is generally doped with a dopant having a positive conductivity and the metal layer comprises nickel or nickel silicide.

16. A method of using the Schottky field-effect transistor switch of Claim 1 to control a flow of current, the substrate being generally doped with a dopant of a first conductivity type, the metal layer comprising a first terminal, the heavily doped region of the substrate comprising a second terminal, and the conductive material in the trench comprising a gate electrode, the method comprising:
creating a voltage difference between the first and second terminals;
during a first time period, biasing the gate electrode to a voltage of the second conductivity type with respect to the second terminal to turn the switch off; and
during a second time period, biasing the gate electrode to a voltage of the first conductivity type with respect to the second terminal to turn the switch on.

17. The method of Claim 16 wherein biasing the gate electrode to a voltage of the second conductivity type with respect to the second terminal comprises biasing the gate electrode to a voltage having an absolute value of one volt or less with respect to the second terminal.

18. The method of Claim 16 wherein biasing the gate electrode to a voltage of the second conductivity type with respect to the second terminal comprises biasing the gate electrode to a voltage having an absolute value equal to at least the absolute value of the voltage difference between the first and second terminals.

19. A method of fabricating a Schottky field-effect transistor switch comprising:
providing a semiconductor substrate doped with a dopant of a first conductivity type;
forming a trench in the substrate, the trench having first and second trench segments separated by a mesa;
forming a dielectric layer on a side wall and a bottom of the trench;
depositing a conductive material in the trench;
forming a second dielectric layer above the conductive material in the trench; and
depositing a metal layer to form a Schottky interface with a surface of the mesa.

20. The method of Claim 19 wherein forming a dielectric layer on a side wall and bottom of the trench comprises forming an oxide layer on the side wall and bottom of the trench.

21. The method of Claim 19 wherein forming a second dielectric layer comprises forming a second oxide layer.

22. The method of Claim 19 wherein depositing a conductive material in the trench comprises depositing doped polysilicon.

23. The method of Claim 19 wherein forming a second oxide layer comprises etching back the polysilicon layer such that a top surface of the polysilicon layer is at a level below the surface of the substrate, and growing a second oxide layer over the polysilicon.

24. The method of Claim 19 wherein providing a semiconductor substrate comprises providing a heavily doped semiconductor piece and growing a lightly doped epitaxial layer on the semiconductor piece.

25. The method of Claim 19 wherein forming a trench comprises cutting through the epitaxial layer into the heavily doped semiconductor piece.

26. The method of Claim 19 comprising implanting a dopant of a second conductivity type into a region of the substrate outside the mesa to form a clamping diode.
